# EUROPEAN PATENT APPLICATION

(11) **EP 4 682 554 A1**
(43) Date of publication of application: **21.01.2026**
(21) Application number: 24189075.5
(22) Date of filing: 17.07.2024
(51) Int. Cl.: G01R 31/26, G05B 23/02, G01R 31/28, G01R 31/42

(54) **METHOD AND APPARATUS FOR MONITORING AN OPERATION OF A CONVERTER**

(71) Applicant: Siemens Aktiengesellschaft, 80333 München (DE)
(72) Inventor: Maul, Christian, 90489 Nürnberg (DE)
(74) Representative: Siemens Patent Attorneys

(57) **Abstract**

A, preferably computer-implemented, method of monitoring an operation of a converter (1), the method comprising the steps of:
determining a lifetime value (D1), e.g., in units of time, energy and/or thermal cycles, of the converter (1), preferably based on determining actual load/fatigue cycles (n1), e.g., current and/or temperature variations of the converter (1), e.g., using a lifetime counting method, for example rainflow counting, preferably based on sensor signals representing a current and/or temperature of the converter (1), in particular the current and/or temperature of the power module (IGBT) of the converter (1), comparing the lifetime value (D1) with a reference value of the lifetime of the converter (1), wherein the reference value is determined based on one or more of an expected lifetime value of the converter (1), one or more use cases of the converter (1), and one or more characteristic duty cycles (40, 50) of the power unit (IGBT) of the converter (1).

## Description

### Technical Field

The present disclosure relates to a, preferably computer-implemented, method of monitoring an operation of a converter. The disclosure further relates to an apparatus, e.g., a converter and/or a computing device coupled to the converter. The disclosure further relates to a computer program.

### Background Art

The operation of a converter leads to heat losses that vary over time, which in turn result in a transient temperature distribution throughout the entire structure. These temperature changes lead to thermo-mechanical stresses in the layer structure of the power module, which can ultimately lead to damages to the individual (semiconductor) layers, such as the solder layers. If the damage progresses, it will ultimately cause the converter to fail. Failures usually have their origin in the fatigue of the bond connections or the processor. In order to obtain an estimate of the service life of a converter, it is known to thermally characterize converters and to examine them in load change tests under standardized alternating loads. This allows general statements to be made as to how many load change cycles a module will function reliably under constant temperature change load. A specific converter or power module therein will then either fail sooner than expected or work longer.

Thermal stress on components, especially semiconductor components such as diodes, transistors or integrated circuits, regularly leads to a shortening of the remaining service life of the component. The remaining service life of a component may be defined by the expected service life of the component minus the current operating time of the component. A failure of the component usually leads to a defect in the electronic circuit that the component has and/or an electrical machine that is connected to the electronic circuit or even the process controlled by the electrical machine. The impending failure of the electronic circuit and thus of the electrical machine represents a high cost risk for the user.

From German patent application DE102010021171A1 a device for determining a service life of an electronic structure, e.g., electrical converter, has become known. Therein, it is proposed to determine the remaining service life of an electronic structure by at least one measuring device for determining a temperature in the region of the electronic structure during operation of the electronic structure. A computing device is designed to determine the frequency of the temperature changes at definable times from the determined temperature and/or the temperature value. In particular, the well-known Rainflow algorithm can be used. Taking into account the frequencies thus determined, the remaining service life is then calculated.

From German patent application DE102013221587A1 a method and a device for determining an expected remaining service life of a component has become known. Therein, the remaining service life of the component is determined from the temperature profile and possibly further parameters and/or load-relevant influences, such as an average voltage, an average current, a frequency of an expected service life of the component. If a remaining service life falls below a specified value, a signal is issued.

From international patent application WO2022263105A1 it has become known to determine the temperature of an electromechanical machine based on the structural data and the electrical operating data, electrical energy losses in the machine are continuously simulated in a spatially resolved manner using an electrical simulation model of the machine.

From European patent application EP 24171297.5 a method of condition monitoring of an electro-mechanical system and/or a process controlled by the electro-mechanical system has become known.

### Summary

By determining the wear on the converter using models commonly used in the art, e.g., rainflow counting, a statement about the wear status of the convert and in particular its semiconductor components, e.g., IGBT, SiC mosfet, diodes, etc., can be determined. If several of these wear indicator readings are stored in a, e.g., permanent, memory in the converter of the drive system, or in external components, such as IIOT or edge devices, an estimate of the theoretical expected service life can be made based on the (changed/changing) values. Such predictions rely on models which themselves rely on idealizations and thus will in principle deviate from the actual wear. Consequently, a prediction of the expected service life may not be accurate.

It is thus an object to improve the monitoring and in particular the accuracy of the prediction of the lifetime of a converter.

According to a first aspect, the object is achieved by a, preferably computer-implemented, method of monitoring an operation of a converter. The method comprising the step of determining a lifetime value, e.g., in units of time, energy and/or thermal cycles, of the converter, preferably based on determining actual load cycles, e.g., current and/or temperature variations of the converter or of one of its components, e.g., using a lifetime counting method, e.g., rainflow counting, for example based on sensor signals representing a current and/or temperature of the converter, in particular the current and/or temperature of the power module of the converter. The method further comprising the step of comparing the lifetime value with a reference value of the lifetime of the converter, wherein the reference value is determined based on one or more of an expected lifetime value of the converter, one or more use cases of the converter, and one or more characteristic duty cycles of the power unit of the converter.

According to a second aspect, the object is achieved by an apparatus, e.g., a converter and/or a computing device coupled to the converter, preferably comprising a processor and a memory, operative to perform the method steps of any one of the preceding claims.

According to a third aspect, the object is achieved by computer program comprising program code that when executed by a processor causes the processor to perform the method steps of any one of the preceding claims.

### Description of Embodiments

Independent of the grammatical term usage, individuals with male, female or other gender identities are included within the term.

### Brief Description of the Drawing

- Figure 1: shows a schematic illustration of a converter powering a drive system.
- Figure 2: shows an illustration of Miner's Rule for calculating damage to a converter.
- Figure 3: shows an equation for calculating the damage according to Miner's Rule.
- Figure 4: shows a first exemplary duty cycle.
- Figure 5: shows a second exemplary duty cycle.
- Figure 6: shows a health indicator in the form of traffic light representing different health states of the converter.

### Detailed Description

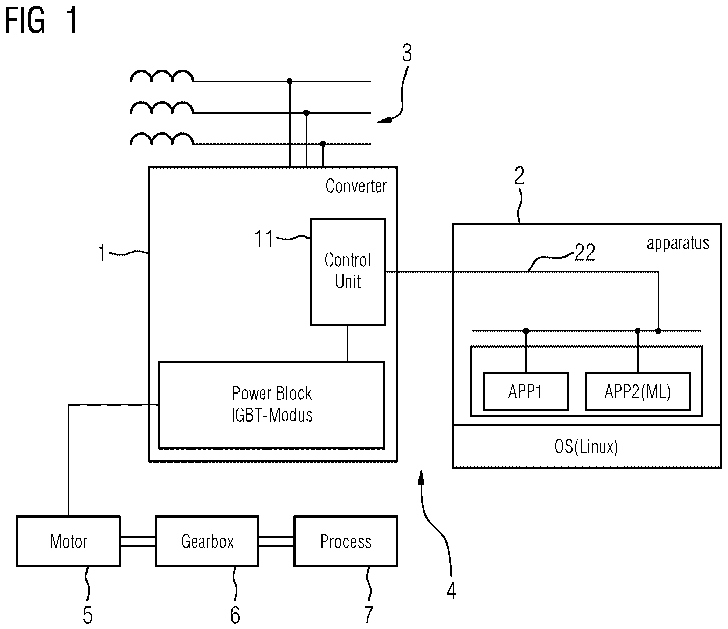

In Figure 1 an electric power converter 1, also denoted as converter in the following, of an electro-mechanical system 4, also denoted as drive system, is shown. The control of the drive system 4 may be performed by the converter 1 and a control unit 11 preferably integrated into the converter 1. To that end, the converter 1 may be part of a control loop and may comprise a processor and a memory to control the drive system 4. The converter 1 hence powers an electrical motor 5 of the drive system 4. The drive system 4 may thus comprise the converter 1, which is coupled to a, e.g., multi-phase, line voltage 3. The drive system 4 may thus further comprise the motor 5. A gearbox 6 may be coupled to the motor 5. The gearbox 6 may be coupled to a load 7, e.g., for performing one or more process steps for controlling a process, e.g., for the in the production and/or processing of a product. The control unit 11 of the converter 1 may control one or more transistors, e.g., insulated-gate bipolar transistors, IGBT, of a power module, which serve as electronic switches for providing electric energy to the motor 5. Alternatively, the motor 5 may be directly coupled to the load 7 and/or line voltage 3, i.e. without a gearbox and/or without a converter.

The converter 1 may be connected to an apparatus 2, e.g. an edge device or another computing device, such as an (industrial) computer. To that end, the control unit 11 of the converter 1 may be connected to a data bus 22 via which operating data, such as actual values and/or setpoint values of the converter are transmitted. The apparatus 2 may comprise one or more analytics software applications, APP1, APP2, i.e. one or more computer programs, e.g., comprising a machine learning model ML, for processing the operating data obtained from the converter 1. Hence, the control unit 11 may provide operating data to the one or more analytics software applications of the apparatus 2. As the case may be, the apparatus 2 may serve for providing connectivity of the converter 1 with a higher-level system such as a cloud computing system, not shown, and/or the apparatus 2 may serve as an on-site computing unit for processing the operating data provided by the converter 1. It should be understood that the data bus 22 is part of the apparatus 2 and may be coupled to the converter 1 via respective interfaces of the converter 1 and apparatus 2. The analytics software applications APP1, APP2 may be executed on an operating system OS, e.g. linux, of the apparatus 2.

Additionally, or alternatively, e.g., in case the motor 5 is directly coupled to the line voltage 3, the apparatus may be coupled to one or more sensors attached to the motor 5 or located in the vicinity of the motor. The one or more sensors may provide the operating data to the apparatus and/or the analytics software applications APP1, APP2 of the apparatus 2. That is the one or more sensors, may provide actual values and/or setpoint values relating to the operation of the electro-mechanical system to the apparatus 2.

The proposed solution is capable of monitoring the drive system 4 including the application specific usage of the drive system 4, respectively. Existing operating data from the converter 1 may be used, in which case no additional measuring sensors may be required. The operating data is used to monitor the operation of the converter and/or detect anomalies in the operation of the drive system 4 and/or the process controlled by the drive system, and in particular the converter. Thereby, one or more deviations from a normal operating state of the drive system and/or the process may be determined.

For the condition monitoring of the electro-mechanical system and/or the controlled process, the operating data is received and further processed. Thereupon, one or more actions may be identified for mitigating and/or resolving a condition causing the anomaly and/or for improving the operation of the converter in particular for extending the lifetime of the converter and/or for adapting a prediction model for predicting the lifetime of the converter. A recommended action can be carried out, e.g. automatically or by a user, in order to mitigate, remove, and/or resolve one or more conditions causing the anomaly or based on a health indicator of the converter. Such conditions may occur, e.g., due to faulty machinery or parts, sensors, or other that equipment can lead to unexpected variations or disruptions in the operation of the electro-mechanical system and/or the controlled process, and may require maintenance, repair and/or replacement. It should be understood that instead of directly and/or actually measuring a current and/or temperature or other physical property of the converter or component thereof, such a sensor signal may be determined e.g. by simulation of the converter and/or the drive system. Hence, instead, or in addition, of an actual sensor a softsensor may be used. The softsensor may be used to determine the sensor signal for determining the lifetime value, e.g., based current and/or temperature signals of the softsensor. The softsensor may rely on a model, e.g., of the converter or component thereof, or a model of the drive system.

Further conditions which need to be monitored, or which for example may alter the service life of the converter may be caused by changes in temperature, humidity, pressure, or other process parameters, which may be adapted by intervening into the control of the process, e.g., by said recommended actions. Still further recommended actions may include varying the setpoints of the electro-mechanical system, in particular in the converter, such as a speed setpoint and/or a torque setpoint of electro-mechanical system, e.g., in the converter.

Any detected anomalies may then be analyzed in more detail. For example, analysis results and corrective measures can be entered and saved by a user. This enables a convenient comparison between anomalies are detected and anomaly situations that are already known and/or stored. This significantly simplifies and speeds up troubleshooting.

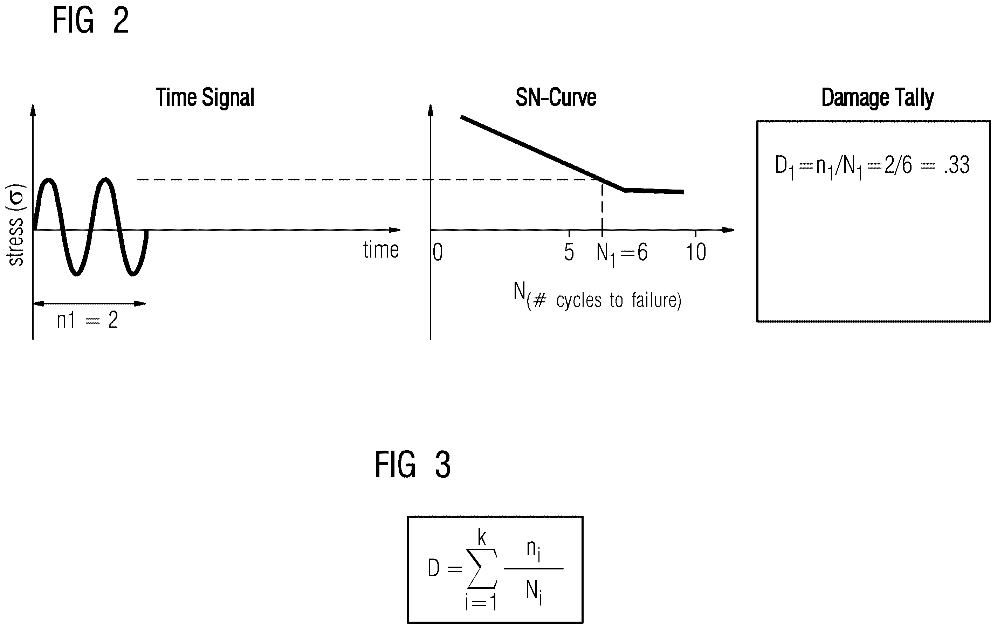

Figure 2 shows an illustration of Miner's Rule, which is used to measure damage and predict failure of a converter or a component, such as a power module, thereof. When a physical part undergoes stress cycles, Miner's Rule may be used to predict the lifetime, i.e., a time until a failure occurs. On the left graph, there is a load over time diagram or history shown. The SN-Curve is the middle graph, and a damage tally is shown on the right side of Figure 2. In this case, two cycles at a specific amplitude are applied to the part. At this amplitude the part could take 6 cycles before it would fail. Dividing two cycles by six cycles, the accumulated damage is 0.33. A third of the life of the part has been used. Thus, two thirds of the lifetime of the part will remain (given the same load cycles are repeated). If two more cycles of a higher amplitude are applied, four cycles would be required for failure to occur. Dividing two cycles by four cycles, an additional 0.5 of damage has occurred. The total accumulated damage is now 0.83. According to Miner's Rule, still no failure has occurred. If then, one more cycle of the higher amplitude is applied the accumulated damage may become now 1.08. Thus, implying that a failure has occurred. The accumulated damage values may thus indicate a lifetime or remaining lifetime of the converter or the power module thereof. The load here may correspond to the current and/or temperature variation or cycles, or thermal cycles as the case may be. The part may correspond to the converter, or a component thereof or to an electrical and/or electro-mechanical device in general.

The equation for Miner's Rule is shown in Figure 3, where D is total damage. Hence, the time period until a certain damage value is reached or until failure occurs may be understood as the lifetime (value) of the part. Again, the part may be a converter, or a component thereof, or an electrical and/or electro-mechanical device in general. When damage is equal to one, failure occurs. n is the number of cycles of a given amplitude that the part or object is subjected to, e.g., in the field or during its lifetime. N is the total number of cycles of a give amplitude that a material can survive, as determined by laboratory testing. k is the number of different amplitude levels of the cycles from the field or lifetime data. Unlike the simple example presented herein, real SN curves for materials such as semiconductor are log-log curves and easily range into millions of cycles. Further "real world" considerations include sequencing or order in which in the cyclic loads are applied. Furthermore, loads applied in the real world are usually not constant amplitude cycles that look like a sine wave. Rather, loads can be applied in a haphazard manner. To break down a "real world" complex load history into cycles, often a cycle counting method called rainflow analysis may be employed.

There are thus assumptions made when calculating the fatigue damage for a part subjected to a cyclical load of constant amplitude using the SN-Curve of the material and Miner's Rule. In addition, in a real-world load-time history, the number of cycles and their respective amplitudes is not easily determined. Thus, the accumulated damage values may not correctly indicate a lifetime or remaining lifetime of the converter or the power module thereof.

Furthermore, load cycles with high temperature differences at the IGBT module result in high thermal loads, and as a consequence in a significant reduction of the IGBT service life. Critical operating conditions with significant cyclic fluctuations of the IGBT chip temperature occur under the following conditions: Periodic duty cycles with pronounced load current fluctuations combined with short switch-on times. Operation at low output frequencies combined with a high output current. The function visualizes the number and the range of the temperature differences in the form of a heatmap. The diagram can be compared over a time period as well as with other assets.

Thus, it should be understood that the load may correspond to a stress and/or fatigue the converter or component therefore is subjected to. Thus, a load cycle may represent or be equal to a stress cycle or a fatigue cycle. Hence, a lifetime value, e.g., in units of time, energy and/or thermal cycles, of the converter may be determined based on determining actual load cycles of the converter (or one or more components thereof), e.g. according to miners rule etc. as described herein. The lifetime value may be determined based on one or more actual stress cycles or based on one or more fatigue cycles. Hithereto, the number of such cycles may be determined.

A converter may also comprise one or more functions for determining the load on the converter. An alternating load counter may be used for this function. In order to detect the actual condition or state of the drive system, a reference measurement may be carried out - this is called a fingerprint. The fingerprint may extend over a period of time that is meaningful enough for the specific application. This means that the fingerprint corresponds to a historical period of time in the database. A plausibility check is performed to ensure the validity of the fingerprint. While the system is operational, continually changing the alternating load counter in the drive system is recorded and evaluated. The values may be compared with the reference gradients, which were determined based on the fingerprint that was recorded. Changed gradients can indicate new operating conditions or an anomaly, which may have a negative impact on the drive service life.

In addition, due to differences in actual manufacturing quality and operating conditions, the life cycle of an IGBT is often asymmetrical to another one, which poses great difficulty in predicting the remaining useful life (RUL) of the IGBTs. The methods for IGBT reliability analysis can be divided into two categories: one is based on statistical methods and the other one is based on the accelerated life test. The statistics models aim to analyze the reliability of the IGBT modules through collected operating data. However, field data of IGBT failure samples are always difficult to collect; so it is very difficult to perform statistical analysis for the IGBT reliability.

It is proposed to improve the reliability of a lifetime prediction and/or to provide a plausibility check for the lifetime prediction of the converter, which lifetime prediction is, e.g., determined based on a lifetime counting method, such as miner's rule and/or rainflow counting. Hitherto, a reference value of the lifetime of the converter may be used. The reference value may be compared to the predicted lifetime value for the converter. Thus, the operation of the converter may be monitored and in particular assessed with respect to the reference value. Thus, a helpful statement or indication about an operating condition can be made by comparing the lifetime value or lifetime estimate with a reference value. This reference value may indicate damage and/or wear and/or may be determined in advance on the basis of known and/or typical duty cycles. For example, an application specific duty cycle may be used for determining the reference value. The reference value may be based on an expected service life of the converter, which may be specified by a user and/or the manufacturer of the converter or component thereof, and/or may thus be assigned to a converter of a specific type or series, e.g., based on the components and/or materials used. The reference value, such as the expected service life or lifespan, may be provided in units of time, energy and/or thermal cycles. The same applies to the lifetime value which may be provided in units of time and/or energy. The reference value may also be provided based on one or more use cases of the converter. A use cases may be associated with a respective duty cycle.

The converter or more specifically the power units may cause a thermal load and may additionally be designed for brief overloads, i.e. the are capable of supplying more than the rated current I_N for short periods. In this instance, the thermal capacity of a heat sink is utilized, allowing for the relevant thermal time constants. The power semiconductors and actual current sensing circuit are rated for a maximum current Imax which must not be exceeded. The overload capability is determined by Imax, I_N and the thermal time constants. A number of characteristic duty cycles may be provided for the power units. The software application may calculate the load on the basis of a (specified) duty cycle with optional time characteristic and/or then determines the thermal load on the power semiconductors. As mentioned, a load, in particular a thermal load, may cause fatigue and/or stress of a part, as, e.g., described herein.

The thermal time constant of a power semiconductor chip is typically within the range of 100 ms. With frequencies below 10 Hz, the overload capacity is therefore limited. The software takes account of these limitations by means of a thermal model and protects the devices against overload in all operating states. It must be noted, especially at frequencies around 0 Hz, that the specified rated current I_N is the root-mean-square value of a sinusoidal current. If the frequency of the three-phase system is reduced to 0 Hz, a pure direct current flows in all phases at standstill. The root-mean-square value of this direct current can reach the peak value of the sinusoidal current depending on the phase relation.

The power modules can be operated with their rated current or power and the specified pulse frequency up to a certain junction temperature of for example 150°C. This corresponds to a certain heat sink temperature. The heat sink reaches the maximum permissible temperature of 150°C at this operating point. Now, if for example the ambient temperature increases, the resulting heat loss must be reduced to prevent the heat sink from overheating. At a given current, the heat loss increases in proportion to the pulse frequency. The rated output current I_N must be reduced to ensure that the maximum heat loss or heat sink temperature for higher pulse frequencies is not exceeded. When the correction factor kf for the pulse frequency is applied, the rated output current I_Nf that is valid for the selected pulse frequency is adjusted. Thus, the operating point of the converter may be controlled, e.g., reducing or increasing, the pulse frequency of the converter, based on the comparison of the lifetime value with a reference value of the lifetime of the converter.

It should be understood that a duty cycle causes a certain load on the converter or more specifically on the power unit(s) of the converter. Thus, having identified a duty cycle (from a plurality of duty cycles) and/or a (corresponding) load the reference value can be determined. To that end, the specified (expected) lifetime of the converter can be determined based on the load. For example, the number of loads in terms of energy the converter is exposed to can be determined. Additionally, this energy can be compared to the total operating energy, e.g. the service life, the converter should withstand or is expected to withstand. Thus, a theoretical number of duty cycles can be determined that the converter should endure when the converter performs that duty cycle. As mentioned, an expected and predetermined lifetime may be provided in units of energy, and thus the number of duty cycles or load cylces (of that duty cycle) can be used to determine the reference lifetime value.

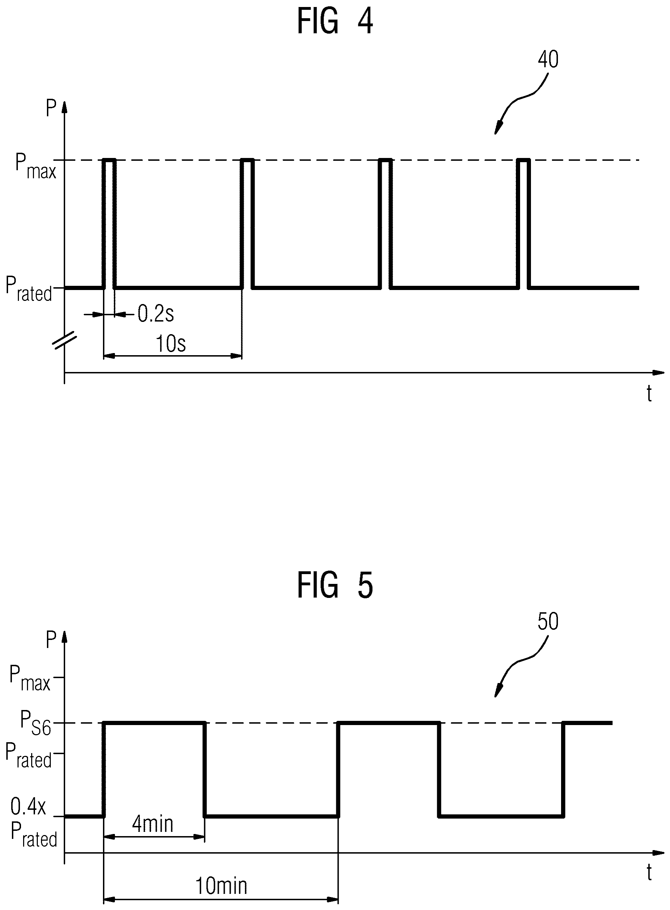

Figures 4 and 5 show duty cycles with different load characteristics, for example of different operating points of a converter or different applications of a converter. A duty cycle or power cycle may be understood as a characteristic curve in which a signal or system is active, e.g., an I-t or P-t curve; i.e. an electrical current over time or a power over time curve. Thus, a duty cycle can be used to describe an electrical device such as the power switch in a switching power supply, i.e. in a converter. The duty cycle is important in power electronic systems because it relates to peak, and/or average power, and/or the timeline of power or current.

Hence, an expected service life of a product such as a converter may be predetermined based on the one or duty cycles the converter is operated in. For example, a converter should withstand 10 years when continuously operated. Thus, a certain duty cycle and/or load cycle, see above, can also be specified that the converter executes or is subject to during the operating time. From this, a wear gradient may be determined and may be used as the reference wear gradient for the determined wear gradient (or its change).

The operation of the converter may cause wear and damage resulting in a shorter lifetime of the converter and in particular the power module. This wear and/or damage may in particular be due to temperature changes in the converter. IGBT chip temperature (depletion-layer) is measured/calculated by the frequency converter with onboard equipment. These values may be transferred to an Industrial Edge PC, or any other computing device, with fast frequency rates (milliseconds to seconds). An app installed on the Industrial Edge PC may feed the microservice "Load cycle analysis" with the data. The microservice analyses the data with different algorithms to detect stressful situation for the IGBT chips. The calculation may be based on a mathematical method called "Rainflow Counting" to extract harmful temperature changes in the IGBT depletion layer temperature. The "Rainflow Counting" method contains mainly 4 steps: Hysteresis filtering, Peak-Valley Filtering, Discretization, Four Point Counting Method. These steps are fully documented in standards such as ASTM E1049 "Standard Practices for Cycle Counting in Fatigue Analysis". The temperature changes will be counted by the algorithm and displayed in a so called heatmap. Development will be based and orientated on this known example and will be adapted to the IGBT specific values like depletion layer temperature. The heatmap (rainflow matrix) shall give the user an idea about the load situations of the drive (IGBTs). The development intends to use generally known procedures and methods and wants to use them now as IGBT stress monitoring feature. Based on the rainflow counting a lifetime value can be determined, or predicted -since it is the outcome of a model of the converter. The (predicted or remaining) lifetime value may then be compared to the reference values.

Now, in order to evaluate the condition or status of a drive and to predict the lifetime of converter components at a customer's site, operating data that is generated by a converter may be used. The operating data may be transferred to an Industrial Edge PC. An app installed on the Industrial Edge PC feeds a microservice, e.g., called "Load cycle analysis", with these warning and alarm data. The microservice analyzes the operating data and may output warning and/or alarm messages and give the user of the application indication of the condition or state of the converter. Furthermore, an artificial intelligence which evaluates the warning and alarm messages to detect some trends to predict upcoming failures may be used. A traffic light may be used as a health indicator of the converter. Thus, the health indicator may be visualized or displayed or otherwise brought to the attention of a user. For example, a yellow light may indicate a deviation between the lifetime value and the reference value exceeding a first threshold (but not exceeding a second threshold). A red light may indicate a deviation between the lifetime value and the reference value exceeding a second threshold (and the first threshold). The second threshold may have an absolute value larger than the first threshold.

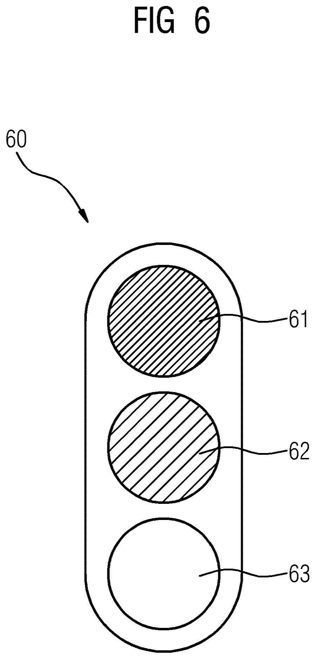

A threshold can be specified that indicates a deviation of 80%-120% between the lifetime value and the reference value. In case when the deviation is between 80%-120% a health indicator may be visualized and/or displayed in green, e.g., signifying that no action is needed and/or that the operation is nominal. In case the deviation is below 80% the health indicator can be visualized and/or displayed by a yellow coloring of the traffic light, e.g., signifying that an action may be taken in order to adapt the operation of the converter and/or to correct the lifetime prediction model. In case of a fault or imminent damage, the indicator may be visualized or displayed by a red light of the traffic light. Such a health state indicator in the form of a traffic light is shown in Figure 6.

Thus, the wear data in the drive system or in the converter, which are stored and evaluated, may be compared against a reference wear. The results of this comparison can assist a user in adapting the operation of the converter and/or be visualized in a way that is easy for the user to understand. Possible visualization variants include:
1. categorizing and/or ordering the result of the comparison in a series of discrete numbers, e.g., 0 to 10, where 0 indicates no relevant wear up to 10 which indicates extremely high wear.
2. categorizing the result in a certain number of groups, for example according to a traffic light system, where green indicates hardly any wear/normal operating conditions, where yellow indicates an increased wear/ service life slightly reduced, and red indicates very high wear.
3. Binary Rating, where an actual wear that is below or above an average wear is indicated.

Furthermore, a buffer in the operation of the converter may be introduced and/or exploited, e.g., compared to 100% accordance between the lifetime value and the reference value. Therein for example in the case of a reduced wear the operation of the converter may be adapted to exploit this buffer or reserve. In that case, the operation of the converter may be adapted. That is, the converter can be controlled, for example to reduce or increase the pulse rate, as the case may be. Alternatively, a model error of the model used for determining the lifetime value can be compensated. To that end, one or more of the model parameters can be adapted. Hence, one or more instruction may be display, e.g., to a user, or otherwise output, e.g. by the converter and/or an apparatus such as a computing device, or more precisely by a computer program executed by a processor of said converter or computing device. The instructions may also relate to remedial measures, such as repair, maintenance and/or replacement. Further remedial measures may include reducing or increasing the temperature, e.g., by increasing or reducing the pulse rate, or in general controlling of the operational parameters of the converter. To that end it should be understood that the stress or wear to the semiconductor material, and/or the converter in general, is dependent on the temperature differences, e.g., in a temperature cycle, in addition to the absolute temperature. Thus, an increase of the base temperature may reduce the stress the converter, IGBTs, and/ or power module is exposed to. Thus, the comparison and/or the one or more thresholds may be used to determine, or identify, a reduced lifetime of the converter and/or a model fault in a lifetime prediction model, e.g. said rainflow counting method.

Furthermore, the continuous change of the thermal load, e.g., given by an alternating load counter, e.g., in the drive system, during ongoing system operation may be recorded and/or evaluated. The values representing the change of the load may be compared with a reference gradient. The reference gradient may be based on a (pre-)recorded fingerprint and/or based on one or more duty cycles as described herein. Changes in the gradient can be due to new operating conditions or an anomaly that has a negative impact on the service life of the drive. Thus, a new operating condition or an anomaly in the operation of the converter may be determined based on the comparison of the change of the gradient with the reference value of the change gradient. For example, from European patent application EP 4160229 A1 a method of monitoring operation of a machine has become known wherein new operating points or an anomaly in the operation can be determined. Furthermore, a power unit overload may be based on a calculated parameter of the converter. A I²t value may be used to determine the temperature rise of the power unit during the duty cycle.

Now alternatively or in addition to visualizing and or displaying a health indicator, the pulse rate of the converter may be controlled, e.g., reduced or increased. This may be done based on the comparison of the lifetime value with the reference value of the lifetime of the converter.

Furthermore, a replacement, maintenance and/or repair of the converter may be determined based on the comparison of the lifetime value with a reference value. Again, one or more of these measures may be based on the comparison of the lifetime value with the reference value and/or with one or more thresholds, e.g., as described herein.

Furthermore, the computer program may serve for carrying out a method according to the present disclosure or of one or more of the embodiments by a processor. The computer program can be stored on a data carrier and can be transported, sold or otherwise used by means of this data carrier and/or by means of downloads from the data carrier. The processor may be part of or may be communicatively and/or operatively coupled to a converter, an edge device or other computing device. The computer program may for example a software application as described herein.

## Claims

1. A, preferably computer-implemented, method of monitoring an operation of a converter (1), the method comprising the steps of:
determining a lifetime value (D1), e.g., in units of time, energy and/or thermal cycles, of the converter, preferably based on determining actual load cycles (n1), e.g., current and/or
temperature variations of the converter (1), e.g., using a lifetime counting method, for example rainflow counting, preferably based on sensor signals representing a current and/or temperature of the converter, in particular the current and/or temperature of the power module (IGBT) of the converter,
comparing the lifetime value (D1) with a reference value of the lifetime of the converter (1),
wherein the reference value is determined based on one or more of an expected lifetime value of the converter, one or more use cases of the converter, and one or more characteristic duty cycles (40, 50), e.g., of the power module (IGBT), of the converter (1).

2. The method according to the preceding claim, further comprising the step of:
determining a health indicator (60, 61, 62, 63) based on the comparison between the lifetime value and the reference value,
outputting the health indicator (60, 61, 62, 63), preferably visualizing/displaying the health indicator or otherwise bringing the health indicator to the attention of a user.

3. The method according to any one of the preceding claims,
wherein depending on a deviation between the lifetime value and the reference value the health indicator (60, 61, 62, 63) takes on one of a plurality of discrete values (61, 62, 63).

4. The method according to any one of the preceding claims, further comprising the step of:
updating the lifetime value during the operation of the converter (1), and
determining a gradient of the lifetime value over time.

5. The method according to the preceding claim, further comprising the step of:
determining a change of the gradient of the lifetime value, and
comparing the change with a reference value of the change gradient.

6. The method according to the preceding claim, further comprising the step of:
determining a new operating condition, or operating point, or an anomaly in the operation of the converter based on the comparison of the change of the gradient with the reference value of the change gradient.

7. The method according to the preceding claim, further comprising the step of:
determining a reduced lifetime of the converter (1) and/or determining a model fault in a lifetime prediction model, e.g. said rainflow counting method.

8. The method according to the preceding claim, further comprising the step of:
controlling an operating point of the converter (1), e.g., reducing or increasing, the pulse frequency of the converter, based on the comparison of the lifetime value with a reference value of the lifetime of the converter (1).

9. The method according to the preceding claim, further comprising the step of:
determining a replacement, maintenance and/or repair of the converter based on the comparison of the lifetime value with a reference value.

10. An apparatus, e.g., a converter (1) and/or a computing device (2) coupled to the converter (1), preferably comprising a processor and a memory, operative to perform the method steps of any one of the preceding claims.

11. A computer program comprising program code that when executed by a processor causes the processor to perform the method steps of any one of the preceding claims.
